**Europäisches Patentamt**

**European Patent Office**

**Office européen des brevets**

(19)

(11) Veröffentlichungsnummer: **0 200 042 B1**

# EUROPÄISCHE PATENTSCHRIFT

(12)

(45) Veröffentlichungstag der Patentschrift: **18.09.91**

(51) Int. Cl.⁵: **H03J 1/04**

(21) Anmeldenummer: **86104838.7**

(22) Anmeldetag: **09.04.86**

(54) **Einrichtung zur Anzeige der Einstellung von elektronischen Funktionsstellern.**

(30) Priorität: **23.04.85 DE 3514586**
**02.04.86 DE 3610992**

(43) Veröffentlichungstag der Anmeldung:
**05.11.86 Patentblatt 86/45**

(45) Bekanntmachung des Hinweises auf die
Patenterteilung:
**18.09.91 Patentblatt 91/38**

(84) Benannte Vertragsstaaten:
**DE FR GB IT**

(56) Entgegenhaltungen:
**DE-A- 2 002 032**
**DE-A- 2 431 119**
**DE-A- 2 833 184**
**DE-C- 848 055**
**FR-A- 2 038 518**

(73) Patentinhaber: **GRUNDIG E.M.V. Elektro-**
**Mechanische Versuchsanstalt Max Grundig**
**holländ. Stiftung & Co. KG.**
**Kurgartenstrasse 37**
**W-8510 Fürth/Bay.(DE)**

(72) Erfinder: **Elsässer, Dieter**
**Tilsiterstrasse 23 A**
**W-8500 Nürnberg(DE)**

## Beschreibung

Die Erfindung betrifft eine Einrichtung zur Anzeige der Einstellung von mit Tipp- oder Sensortasten betätigbaren elektronischen Funktionsstellern.

Bei herkömmlichen, als Dreh- oder Schiebepotentiometer ausgebildeten mechanischen Funktionsstellern ist die Einstellung direkt aus der Stellung der einzelnen mit einer Markierung versehenen Bedienknöpfe, gegebenenfalls bezüglich geeigneter Skalen, erkennbar. Mit Tipp- oder Sensortasten betätigbare elektronische Funktionssteller dagegen benötigen hierfür eine separate Anzeigeeinrichtung. Es ist bekannt, für eine solche Anzeigeeinrichtung eine der Anzahl der Funktionssteller entsprechende Anzahl von LED-Ketten zu verwenden. Hierdurch wird zwar eine sehr genaue quantitative Anzeige für die Einstellung der elektronischen Funktionssteller erreicht. Jedoch erfordern derartige LED-Ketten einen hohen technischen und damit auch kostenmäßigen Aufwand hinsichtlich ihrer Ansteuerung. Dieser Nachteil macht sich insbesondere bei Geräten bemerkbar, die zur Bedienung eine größere Anzahl von Funktionsstellern benötigen (Vgl. DE-A-20 02 032).

Aus der DE-A-24 31 119 ist es ferner bekannt, die Einstellung eines Funktionsstellers durch den Farbton oder die Farbkombination einer Leuchtdioden-Anordnung anzuzeigen. Die Normalstellung des Funktionsstellers soll dabei durch einen bestimmten Farbton oder durch die zeitgleiche Folge zweier wechselweise abgestrahlter, unterschiedlicher Farben gekennzeichnet werden. Zur Erzeugung spezieller Farbtöne wird entsprechend der vorgenannten Offenlegung das Licht zweier Leuchtdioden optisch gemischt, die geometrisch dicht nebeneinander montiert sind, so daß sie aus größerer Entfernung als homogene Lichtquelle erscheinen.

Die Auswertung des Farbtones bei gleitender Farbänderung erlaubt jedoch keine genaue Abschätzung der absoluten Einstellung des Stellgliedes, solange keine unmittelbare Vergleichsmöglichkeit zum Farbton bei Normalstellung des Funktionsstellers gegeben ist.

Der Erfindung liegt deshalb die Aufgabe zugrunde, eine Einrichtung zur quantitativen Anzeige der Einstellung von mit Tipp- oder Sensortasten betätigbaren elektronischen Funktionsstellern zu schaffen, die sich durch einen einfachen technischen Aufbau auszeichnet und die es dem Betrachter dennoch erlaubt, möglichst genau auf die Einstellung der Funktionssteller zu schließen.

Diese Aufgabe wird gemäß der Erfindung durch die in den Patentansprüchen 1 oder 5 angegebenen Merkmale gelöst. Vorteilhafte Ausgestaltungen der Erfindung sind in den jeweiligen Unteransprüchen gekennzeichnet.

Bei der Einrichtung gemäß der Erfindung wird in vorteilhafter Weise die Fähigkeit des menschlichen Auges ausgenutzt, geringe Leuchtdichtedifferenzen oder Farbtonunterschiede benachbarter Lichtquellen zu erfassen und zu bewerten. Hierzu ist jedem Funktionssteller ein jeweils erstes Leuchtfeld zugeordnet, dessen Helligkeit oder dessen Farbton abhängig von der Einstellung des entsprechenden Funktionsstellers steuerbar ist. Als Vergleichsnormal ist jedem Funktionssteller ferner ein jeweils zweites Leuchtfeld zugeordnet, dessen Helligkeit bzw. Farbton konstant auf dem Mittelwert des von dem ersten Leuchtfeld überstreichbaren Helligkeitsbereiches bzw. Farbspektrums gehalten wird.

Bei einer bevorzugten Ausführungsform der Einrichtung gemäß der Erfindung sind die jeweils zweiten Leuchtfelder zu einem allen Funktionsstellern gemeinsamen zweiten Leuchtfeld vereinigt, das als Vergleichsnormal für alle in der Helligkeit bzw. im Farbton steuerbaren ersten Leuchtfelder dient.

Eine weitere bevorzugte Ausführungsform der Einrichtung gemäß der Erfindung zeichnet sich dadurch aus, daß die den einzelnen Funktionsstellern zugeordneten ersten Leuchtfelder innerhalb des gemeinsamen zweiten Leuchtfeldes liegen.

Für Leuchtfelder, die in ihrer Helligkeit steuerbar sein sollen, eignen sich als Lichtquellen in vorteilhafter Weise Leuchtdioden, die in Kombination mit geeigneten Kunststoffteilen diffusleuchtende Flächen bzw. Felder bilden. Auch LCD-Elemente können bei entsprechender Ansteuerung und Betriebsart (z.B. Transmissionsbetrieb) in besonderer Weise als Leuchtfelder dienen.

Für Leuchtfelder, die in ihrem Farbton steuerbar sein sollen, eignen sich insbesondere optoelektronische Anordnungen, die jeweils aus einer Reihe von Lichtleitfasern und mehreren, insbesondere drei verschiedenfarbigen Lichtquellen bestehen. Hierbei ist eine erste Anzahl der Lichtleitfasern von der ersten Lichtquelle, eine zweite Anzahl von der zweiten Lichtquelle und eine dritte Anzahl von der dritten Lichtquelle beleuchtbar. Die Lichtaustrittsenden der Lichtleitfasern sind in vorteilhafter Weise zu Farbtripeln zusammengefaßt in der jeweiligen Leuchtfeldebene angeordnet. Die Lichtquellen selbst strahlen vorzugsweise Licht in den Farben rot, grün und blau ab, so daß über die Intensitäten der Lichtquellen in der jeweiligen Leuchtfeldebene jeder beliebige Farbton erzeugbar ist. Hierbei sind die Intensitäten der Lichtquellen, die die Lichtleitfasern der ersten Leuchtfelder beleuchten, mit der Einstellung der Funktionssteller steuerbar, wodurch bewirkt wird, daß das jeweilige Leuchtfeld seinen Farbton mit der Einstellung des zugehörigen Funktionsstellers ändert.

Eine weitere Möglichkeit, Leuchtfelder mit veränderbarem Farbton zu realisieren, besteht darin, die optoelektronischen Anordnungen als Penetrationskathodenstrahlröhren auszubilden. Derartige Röhren zeichnen sich dadurch aus, daß die Farbe ihres Leuchtschirms abhängig ist von der Höhe der Beschleunigungsspannung für die Elektronen. Wird nun die Regelung für diese Beschleunigungsspannung direkt mit der Einstellung eines Funktionsstellers gekoppelt, so ergibt sich ein unmittelbarer Zusammenhang zwischen der Einstellung des Funktionsstellers und dem Farbton des von der genannten Röhre gebildeten Leuchtfeldes.

Gegenüber Leuchtfeldern, die in ihrer Helligkeit steuerbar sind, haben Leuchtfelder mit veränderbarem Farbton den Vorteil, daß mit ihnen eine differenziertere Bewertung und damit ein genauerer Rückschluß auf die Einstellung der Funktionssteller möglich ist. Dies basiert auf der Erkenntnis, daß das menschliche Auge auf Farbtonunterschiede wesentlich empfindlicher reagiert, als auf Helligkeits- bzw. Leuchtdichtedifferenzen. Die Zahl der Farbtonstufen, die für das menschliche Auge unterscheidbar sind, ist wesentlich größer als die Zahl der erkennbaren Graustufen.

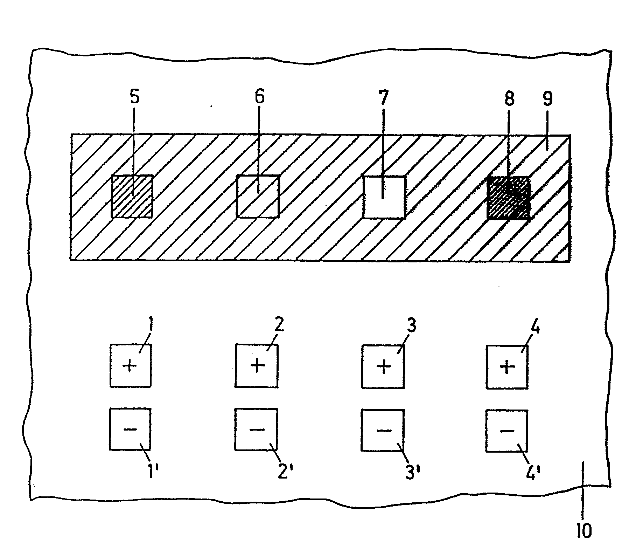

Die Erfindung ist im folgenden anhand einer Zeichnung näher erläutert. Die Figur zeigt ein bevorzugtes Ausführungsbeispiel einer Einrichtung gemäß der Erfindung.

Die dargestellte Einrichtung ist für vier über Tipptasten 1 bis 4 und 1' bis 4' betätigbare Funktionssteller ausgelegt. Jedem Paar von Tipptasten, die innerhalb eines Bedienfeldes 10 angeordnet sind, ist ein in der Helligkeit oder im Farbton steuerbares Leuchtfeld 5, 6, 7 bzw. 8 zugeordnet. Die genannten Leuchtfelder 5 bis 8 werden von einem Leuchtfeld 9 umgeben, dessen Helligkeit bzw. Farbton konstant gehalten wird.

Für den Fall, daß es sich bei den betreffenden Funktionsstellern z.B. um getrennte Baß- und Höhenregler eines Stereogerätes handelt, wird bei einer Betätigung der mit " + " gekennzeichneten Tipptasten 1 bis 4 eine Anhebung und der mit "-" gekennzeichneten Tipptasten 1' bis 4' eine Absenkung des jeweiligen Frequenzbereiches bewirkt. Mit der Betätigung einer Tipptaste erfolgt gleichzeitig eine Helligkeitssteuerung des zugeordneten Leuchtfeldes bzw. über eine Intensitätssteuerung verschiedenfarbiger Lichtquellen eine Farbtonsteuerung des zugeordneten Leuchtfeldes.

Bei in der Helligkeit steuerbaren Leuchtfeldern zieht eine Anhebung der Frequenzbereiche (Tasten 1 bis 4) ein Hellerwerden und eine Absenkung (Tasten 1' bis 4') ein Dunklerwerden der Leuchtfelder 5 bis 8 nach sich. Das Leuchtfeld 9 wird hierbei auf einem Helligkeits-Mittelwert gehalten, der als Vergleichsnormal dient und der sich bei den steuerbaren Leuchtfeldern 5 bis 8 genau dann ergibt, wenn für die entsprechenden Funktionssteller eine Einstellung gewählt wird, die zwischen der größten Anhebung und der größten Absenkung eines Frequenzbereiches liegt. In vorteilhafter Weise kann in der Nähe des Anzeigefeldes noch zusätzlich eine Grauwertskala vorgesehen werden, die ebenfalls zum Vergleich dient und mit deren Hilfe sich abschätzen läßt, wie weit eine augenblickliche Einstellung noch von dem einen oder anderen Extremwert (maximale Anhebung oder Absenkung) entfernt ist.

Bei im Farbton steuerbaren Leuchtfeldern reicht das überstreichbare Farbspektrum von dunkelblau, z. B. bei größter Absenkung, über hellblau, grün, gelb, orange und rot bis zu violett, z. B. bei größter Anhebung. Das Leuchtfeld 9 wird hierbei auf einem Mittelwert - vorzugsweise grün - des von den ersten Leuchtfeldern überstreichbaren Farbspektrums gehalten, der als Vergleichsnormal dient und der sich bei den steuerbaren Leuchtfeldern 5 bis 8 genau dann ergibt, wenn für die entsprechenden Funktionssteller eine Einstellung gewählt wird, die zwischen der größten Anhebung und der größten Absenkung eines Frequenzbereiches liegt. In vorteilhafter Weise kann auch in diesem Fall in der Nähe des Anzeigefeldes noch zusätzlich eine Farbwertskala vorgesehen werden, die ebenfalls zum Vergleich dient und mit deren Hilfe sich abschätzen läßt, wie weit eine augenblickliche Einstellung noch von dem einen oder anderen Extremwert (maximale Anhebung oder Absenkung) entfernt ist.

**Patentansprüche**

1. Einrichtung zur Anzeige der Einstellung von mit Tipp- oder Sensortasten betätigbaren elektronischen Funktionsstellern, **dadurch gekennzeichnet,** daß jedem Funktionssteller (1, 1'; 2, 2'; 3, 3'; 4, 4';) ein jeweils erstes Leuchtfeld (5, 6, 7, 8) zugeordnet ist, dessen Helligkeit abhängig von der Einstellung des entsprechenden Funktionsstellers steuerbar ist, und daß jedem Funktionssteller ein jeweils zweites Leuchtfeld (9) zugeordnet ist, dessen Helligkeit als Vergleichsnormal konstant auf dem Mittelwert des von dem ersten Leuchtfeld überstreichbaren Helligkeitsbereiches gehalten wird.

2. Einrichtung nach Anspruch 1, dadurch gekennzeichnet, daß als Lichtquellen Leuchtdioden verwendet werden, die in Kombination mit geeigneten Kunststoffteilen diffus strahlende Leuchtfelder bilden.

3. Einrichtung nach Anspruch 1, dadurch gekennzeichnet, daß als Leuchtfelder LCD-Elemente verwendet werden.

4. Einrichtung nach einem oder mehreren der Ansprüche 1 bis 3, dadurch gekennzeichnet, daß in der Nähe des Anzeigefeldes eine Grauwertskala vorgesehen ist.

5. Einrichtung zur Anzeige der Einstellung von mit Tipp- oder Sensortasten betätigbaren elektronischen Funktionsstellern, denen jeweils ein erstes Leuchtfeld zugeordnet ist, dessen Farbton mit Hilfe einer optoelektronischen Anordnung in Abhängigkeit der Einstellung des entsprechenden Funktionsstellers steuerbar ist, **dadurch gekennzeichnet,** daß jedem Funktionssteller ein jeweils zweites Leuchtfeld zugeordnet ist, dessen Farbton als Vergleichsnormal mit Hilfe einer weiteren optoelektronischen Anordnung auf den Mittelwert des von dem ersten Leuchtfeld überstreichbaren Farbspektrums gehalten wird.

6. Einrichtung nach Anspruch 5, dadurch gekennzeichnet, daß die optoelektronischen Anordnungen jeweils aus einer Reihe von Lichtleitfasern und vorzugsweise drei verschiedenfarbigen Lichtquellen bestehen, daß eine erste Anzahl der Lichtleitfasern von der ersten Lichtquelle, eine Zweite Anzahl von der Zweiten Lichtquelle und eine dritte Anzahl von der dritten Lichtquelle beleuchtbar ist, und daß die Lichtaustrittsenden der Lichtleitfasern Zu Farbtripeln zusammengefaßt in der jeweiligen Leuchtfeldebene angeordnet sind.

7. Einrichtung nach Anspruch 6, dadurch gekennzeichnet, daß die Lichtquellen, die die Lichtleitfasern der ersten Leuchtfelder beleuchten, in ihrer Intensität mit der Einstellung der Funktionssteller steuerbar sind.

8. Einrichtung nach Anspruch 6 oder 7, dadurch gekennzeichnet, daß die Lichtquellen Licht in den Farben rot, grün und blau abstrahlen.

9. Einrichtung nach Anspruch 5, dadurch gekennzeichnet, daß die optoelektronischen Anordnungen als Penetrationskathodenstrahlröhren ausgebildet sind.

10. Einrichtung nach einem oder mehreren der Ansprüche 5 bis 9, dadurch gekennzeichnet, daß in der Nähe des Anzeigefeldes eine Farbwertskala vorgesehen ist.

11. Einrichtung nach einem oder mehreren der Ansprüche 1 bis 10, dadurch gekennzeichnet, daß die zweiten Leuchtfelder zu einem allen Funktionsstellern gemeinsamen Zweiten Leuchtfeld (9) vereinigt sind.

12. Einrichtung nach Anspruch 11, dadurch gekennzeichnet, daß die den einzelnen Funktionsstellern zugeordneten ersten Leuchtfelder (5, 6, 7, 8) innerhalb des gemeinsamen zweiten Leuchtfeldes (9) liegen.

**Claims**

1. Device for displaying the setting of electronic function actuators which can be activated using touch control or sensor key, characterised in that each function actuator (1, 1'; 2, 2'; 3, 3'; 4, 4';) has in each case a first indicator field (5, 6, 7, 8) assigned to it, the brightness of which field is controllable as a function of the setting of the corresponding function actuator, and in that each function actuator has in each case a second indicator field (9) assigned to it, the brightness of which indicator field is constantly held at the average value of the range of brightness which can be covered by the first indicator field as a comparison standard.

2. Device according to Claim 1, characterised in that LEDs are used as light sources which in conjunction with suitable plastic parts form diffusely radiating indicator fields.

3. Device according to Claim 1, characterised in that LCD elements are used as indicator fields.

4. Device according to one or more of Claims 1 to 3, characterised in that a grey value scale is provided in the vicinity of the indicator field.

5. Device for displaying the setting of electronic function actuators which can be activated using touch control or sensor keys, to which function actuators in each case a first indicator field is assigned, the shade of colour of which can be controlled with the aid of an opto-electronic arrangement as a function of the setting of the corresponding actuator, characterised in that each function actuator has in each case a second indicator field assigned to it, the shade of colour of which is held, as a comparison standard, at the average value of the colour spectrum which can be covered by the first indicator field, with the aid of a further opto-electronic arrangement.

6. Device according to Claim 5, characterised in that the opto-electronic arrangements consist in each case of a series of optical fibres and preferably three differently coloured light sources, in that a first number of optical fibres can be illuminated by the first light source, a second number by the second light source and a third number by the third light source, and in that the light emergence ends of the optical fibres, combined to form colour triads, are arranged in the respective indicator field plane.

7. Device according to Claim 6, characterised in that the light intensity of the light sources which illuminate the optical fibres of the first indicator fields can be controlled using the setting of the function actuators.

8. Device according to Claim 6 or 7, characterised in that the light sources radiate light of the colours red, green and blue.

9. Device according to Claim 5, characterised in that the opto-electronic arrangements are constructed as penetration cathode ray tubes.

10. Device according to one or more of Claims 5 to 9, characterised in that a colour value scale is provided in the vicinity of the indicator field.

11. Device according to one or more of Claims 1 to 10, characterised in that the second indicator fields are combined to form a second indicator field (9) common to all function actuators.

12. Device according to Claim 11, characterised in that the first indicator fields (5, 6, 7, 8) assigned to the individual function actuators are located within the common second indicator field (9).

**Revendications**

1. Dispositif pour indiquer le réglage de régulateurs électroniques de fonctions, pouvant être actionnés à l'aide de touches à impulsion ou de touches de détection, caractérisé par le fait qu'à chaque régulateur de fonction (1,1'; 2,2'; 3,3'; 4,4') est associé une première zone lumineuse (5,6,7,8), dont la luminosité est commandable en fonction du réglage du régulateur de fonction correspondant et qu'à chaque régulateur de fonction est associée une seconde zone lumineuse respective (9), dont la luminosité est, en tant qu'étalon de référence, maintenue constante à la valeur moyenne de la gamme de luminosité pouvant être couverte par la première zone lumineuse.

2. Dispositif selon la revendication 1, caractérisé en ce qu'on utilise, comme sources de lumière, des diodes à luminescence, qui, en combinaison avec des pièces appropriées en matière plastique, forment des zones lumineuses émettant un rayonnement diffus.

3. Dispositif selon la revendication 1, caractérisé en ce qu'on utilise comme zones lumineuses, des éléments LCD.

4. Dispositif selon une ou plusieurs des revendications 1 à 3, caractérisé en ce qu'une échelle des gris est prévue à proximité du panneau d'affichage.

5. Dispositif pour afficher le réglage de régulateurs électroniques de fonctions pouvant être actionnés par des touches à impulsion ou des touches de détection et auxquels est associé respectivement une première zone lumineuse, dont la couleur est commandable à l'aide d'un dispositif optoélectronique en fonction du réglage du régulateur de fonction correspondant, caractérisé en ce qu'à chaque régulateur de fonction est associé une seconde zone lumineuse respective, dont la couleur est, en tant qu'étalon de référence, maintenue égale à la valeur moyenne du spectre des couleurs, que peut couvrir la première zone lumineuse, au moyen d'un autre dispositif optoélectronique.

6. Dispositif selon la revendication 5, caractérisé en ce que les dispositifs optoélectroniques sont constitués respectivement par une série de fibres optiques et de préférence par trois sources de lumière possédant des couleurs différentes, et qu'un première nombre des fibres optiques peut être éclairé par la première source de lumière, qu'un second nombre de fibres optiques peut être éclairé par la seconde source de lumière et qu'un troisième nombre de fibres optiques peut être éclairé par la troisième source de lumière et que les extrémités de sortie de la lumière des fibres optiques sont réunies pour former un triplet de couleurs, dans le plan respectif des zones lumineuses.

7. Dispositif selon la revendication 6, caractérisé en ce que les sources de lumière, qui éclairent les fibres optiques des premières zones lumineuses, sont-commandables en intensité au moyen du réglage des régulateurs de fonctions.

8. Dispositif selon la revendication 6 ou 7, caractérisé en ce que les sources de lumière émettent une lumière dans les couleurs rouge, verte et bleue.

9. Dispositif selon la revendication 5, caractérisé en ce que les dispositifs optoélectroniques sont agencés sous la forme de tubes cathodiques à pénétration.

10. Dispositif selon une ou plusieurs des revendications 5 à 9, caractérisé en ce qu'une échelle des couleurs est prévue à proximité du panneau d'affichage.

11. Dispositif selon une ou plusieurs des revendications 1 à 10, caractérisé en ce que les secondes zones lumineuses sont réunies pour former une seconde zone lumineuse (9) commune à tous les régulateurs de fonctions.

12. Dispositif selon la revendication 11, caractérisé en ce que les premières zones lumineuses (5,6,7,8) associées aux différents régulateurs de fonctions sont situées à l'intérieur de la seconde zone lumineuse commune (9).